Europäisches Patentamt

European Patent Office

Office européen des brevets

(11) Publication number: **0 282 593 B1**

# EUROPEAN PATENT SPECIFICATION

(45) Date of publication of patent specification: **15.09.93**   (51) Int. Cl.5: **B23K   26/06**

(21) Application number: **87904116.8**

(22) Date of filing: **25.06.87**

(86) International application number:
**PCT/JP87/00420**

(87) International publication number:
**WO 88/00108 (14.01.88 88/02)**

(54) **LASER BEAM FORMING APPARATUS.**

(30) Priority: **08.07.86 JP 158844/86**
     **30.07.86 JP 177666/86**

(43) Date of publication of application:
**21.09.88 Bulletin  88/38**

(45) Publication of the grant of the patent:
**15.09.93 Bulletin  93/37**

(84) Designated Contracting States:
**DE FR GB**

(56) References cited:
**EP-A- 0 121 069**
**US-A- 3 947 093**
**US-A- 3 972 599**
**US-A- 4 564 736**

(73) Proprietor: **KABUSHIKI KAISHA KOMATSU
SEISAKUSHO**
**3-6, Akasaka 2-chome**
**Minato-ku Tokyo 107(JP)**

(72) Inventor: **OKAMURA, Kazuo**
**6-5-106, Ueno 2-chome**
**Hirakata-shi Osaka-fu 573(JP)**
Inventor: **HISADA, Hideo**
**37-18, Himurodai 1-chome**
**Hirakata-shi Osaka-fu 573-01(JP)**
Inventor: **MARUO, Hiroshi**
**15-13, Nakayama-Satsukidai 3-chome**
**Takarazuka-shi Hyogo-ken 665(JP)**
Inventor: **MIYAMOTO, Isamu**
**1-12, Koshien 4-bancho**
**Nishinomiya-shi Hyogo-ken 663(JP)**

(74) Representative: **Lemoine, Michel et al
CABINET LEMOINE ET BERNASCONI 13, Bou-
levard des Batignolles
F-75008 Paris (FR)**

## Description

This invention relates to a laser beam forming apparatus according to the preamble of claim 1 and of claim 10.

## BACKGROUND ART OF THE INVENTION

In Japanese Patent Publication NO. SHO57-47249, there is disclosed a laser beam forming apparatus wherein an internal reflecting mirror having a mirror-finished cylindrical circumferential surface is mounted in a light beam optical system such as, for example, a laser beam optical system so that laser beams may be focussed through the reflecting mirror with a uniform energy density (or energy distribution). In such a conventional laser beam forming apparatus, in order to form the above-mentioned internal reflecting mirror having a mirror-finished inside peripheral surface, it is necessary to conduct high precision working and assembly so as to align the axis of laser beams and that of the mirror surface of the internal reflecting mirror. As a matter of fact, however, it is almost impossible to conduct such high precision working and assembly required, and as a result, it was difficult to obtain readily laser beams having a uniform energy distribution. Further, the energy distribution of the laser beams to be irradiated on an object to be processed thereby is in a similar relationship with that of the laser beams incident on a beam focussing lens before focussing, and therefore if the energy distribution of the laser beams before focussing is not uniform, then the laser beams to be irradiated onto the object to be worked thereby will become uneven. For example, in case of laser hardening, if laser beams having an uneven energy distribution are used for irradiation, then such disadvantages as uneven hardening pattern and partial melting of the surface of the object to be hardened will occur.

On the other hand, there has already been well-known a mirror irradiation system wherein laser beams are reflected through a plurality of mirrors divided into a grid shape and then the reflected laser beams are focussed at the same one point to thereby make uniform the energy distribution of laser beams for irradiation, so-called segment mirror system. This segment mirror system has the following disadvantage. Stating in brief, this system requires high precision in working or machining and mounting of the mirrors, and as a result, the manufacturing cost of the mirrors becomes expensive, and also because the shape of the laser beams is fixed, there is need for replacement of mirrors for each of the objects to be irradiated therewith.

Further, there has been known a laser beam forming apparatus comprising a plurality of reflecting mirrors with the above-mentioned segment-mirrors interposed to achieve more uniform energy distribution of laser beams to be irradiated. In such an apparatus, however, the greater the number of the reflecting mirrors, the greater the drop in the output of laser beams, and the larger the size of the whole apparatus, and further the outside energy distribution of the laser beams being irradiated becomes divergent.

Moreover, for the purpose of forming laser beams having energy distribution of a ring mode, in particular, there has so far been generally known an apparatus employing an unstable type resonator. However, the energy distribution of the laser beams for irradiation formed by this apparatus was lacking in stability and uniformity. To remedy this disadvantage, there has been developed an apparatus for forming laser beams of a superficial ring mode by rotating a mirror having an inclined eccentric shaft at a high speed. However, this improved apparatus has unsolved points at issue in that (a) it lacks in stability for mode formation since it has a motor driving unit; (b) it is difficult to set the size of beams; whether the energy distribution of the laser beams to be formed by the apparatus is satisfactory or not depends on whether the energy distribution of the laser beams before focussing is satisfactory or not etc.

## SUMMARY OF THE INVENTION

The present invention has been made to solve the disadvantages and points at issue associated with the above-mentioned conventional laser beam forming apparatuses, and has for its object to provide a laser beam forming apparatus which does not require high precision working to form the mirror surface in the reflecting mirror and which can form readily laser beams having a macroscopically uniform energy distribution, even if the focussed incident beams are not uniform.

Another object of the present invention is to provide a laser beam forming apparatus wherein laser beams are allowed to make incidence from one end of a sleeve member whose inside surface is mirror-finished so as to achieve an extremely enhanced reflectivity, so that the laser beams may be subjected to multi-reflection therein, and then the multi-reflected laser beams are synthesized on the other end of the sleeve member.

To achieve the above-mentioned objects, in accordance with the first aspect of the present invention, there is provided a laser beam forming apparatus made in accordance with claim 1.

An apparatus according to the pre-characterising part of claim 1 is known from document EP-A-121 069. In this document, the laser beam is deflected by a number of optical path components which increase the length of the apparatus and there is generated an output laser beam which is not convergent but parallel and which could not be used for laser beam machining.

According to a second aspect of the invention, there is provided a laser beam forming apparatus made in accordance with claim 10.

The above-mentioned and other advantages, aspects and objects of the present invention will become apparent to those skilled in the art from the following detailed description taken in conjunction with the accompanying drawings in which preferred embodiments incorporating the principles of the present invention are shown.

## BRIEF DESCRIPTION OF ACCOMPANYING DRAWINGS

Figure 1 is a schematic side elevational view showing the main parts of the optical system according to a first embodiment of the laser beam forming apparatus of the present invention;

Figures 2 and 3 are views taken along lines with arrows II-II and III - III, respectively;

Figure 4 is a schematic side elevational view showing the main parts of the optical system according to a second embodiment of the laser beam forming apparatus of the present invention;

Figures 5 and 6 are views taken along lines with arrows V - V and VI - VI, respectively;

Figure 7 is a schematic side elevational view showing the main parts of the optical system according to a third embodiment of the laser beam forming apparatus of the present invention;

Figures 8 and 9 are schematic side elevational views showing the main parts of the optical system according to fourth and fifth embodiments of the laser beam forming apparatus of the present invention;

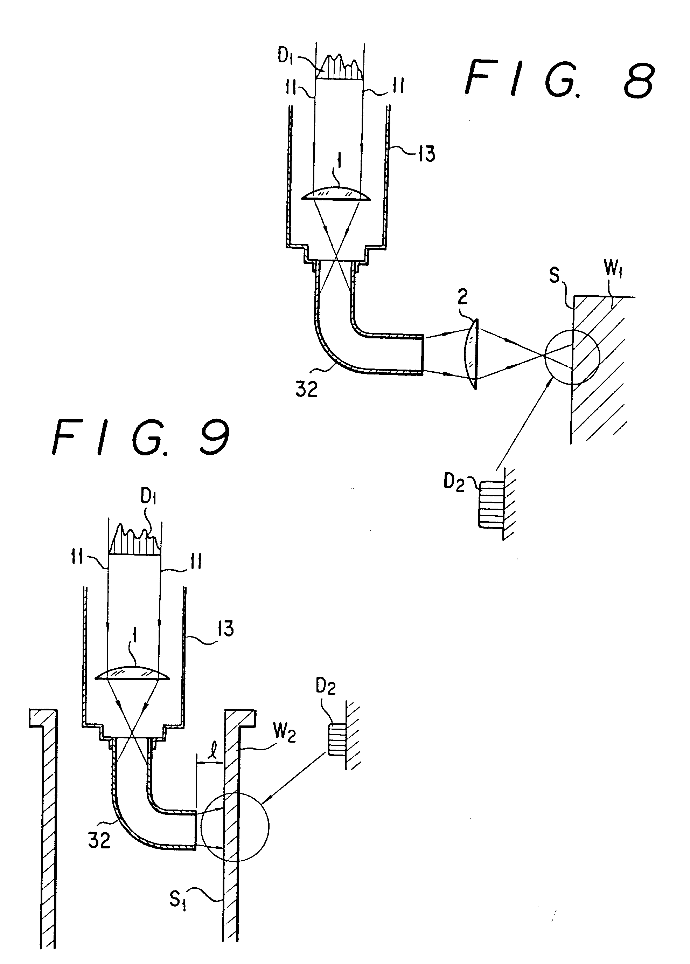

(The embodiment of Fig. 9 does not fall within the scope of the claims)

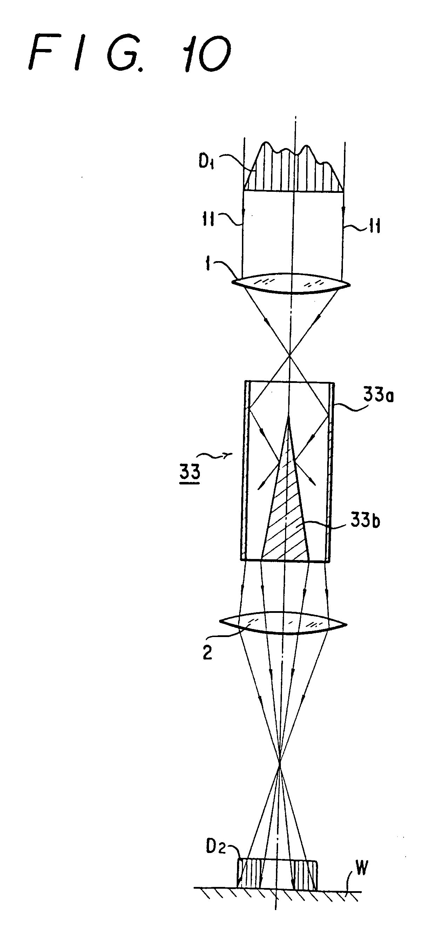

Figure 10 is a schematic side elevational view showing the main parts of the optical system according to a sixth embodiment of the laser beam forming apparatus of the present invention;

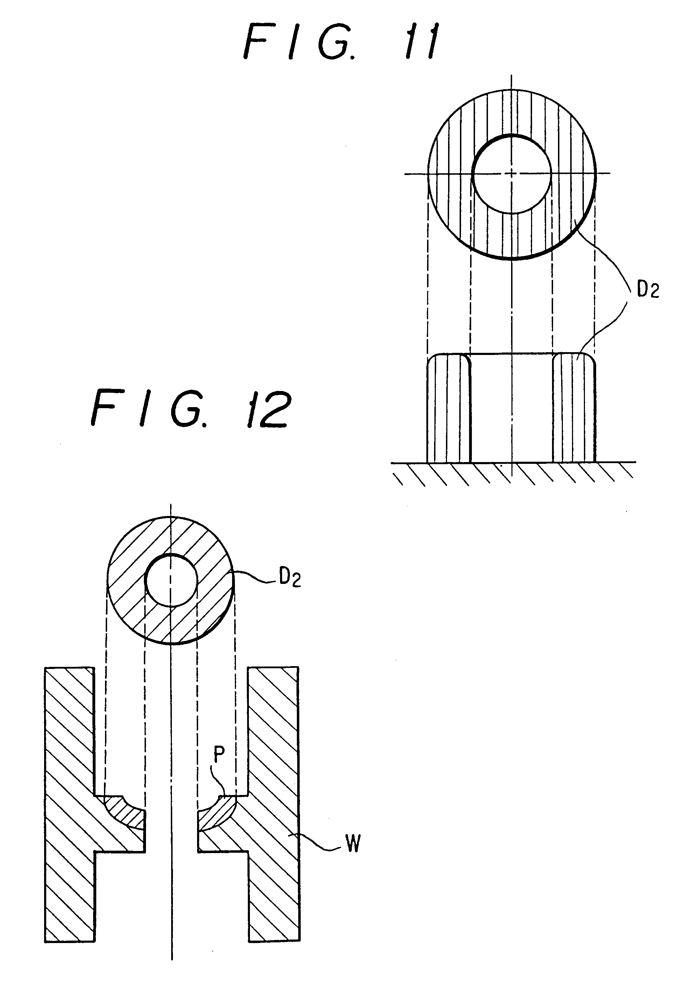

Figure 11 is an explanatory view of the laser beams of a ring made formed by the laser beam forming apparatus shown in Figure 10; and

Figure 12 is an explanatory view of laser hardening to be made by using the laser beams of a ring mode.

## DESCRIPTION OF THE BEST MODE OF THE INVENTION

The laser beam forming apparatus of the present invention will now be described in detail below by way of several embodiments with reference to the accompanying drawings.

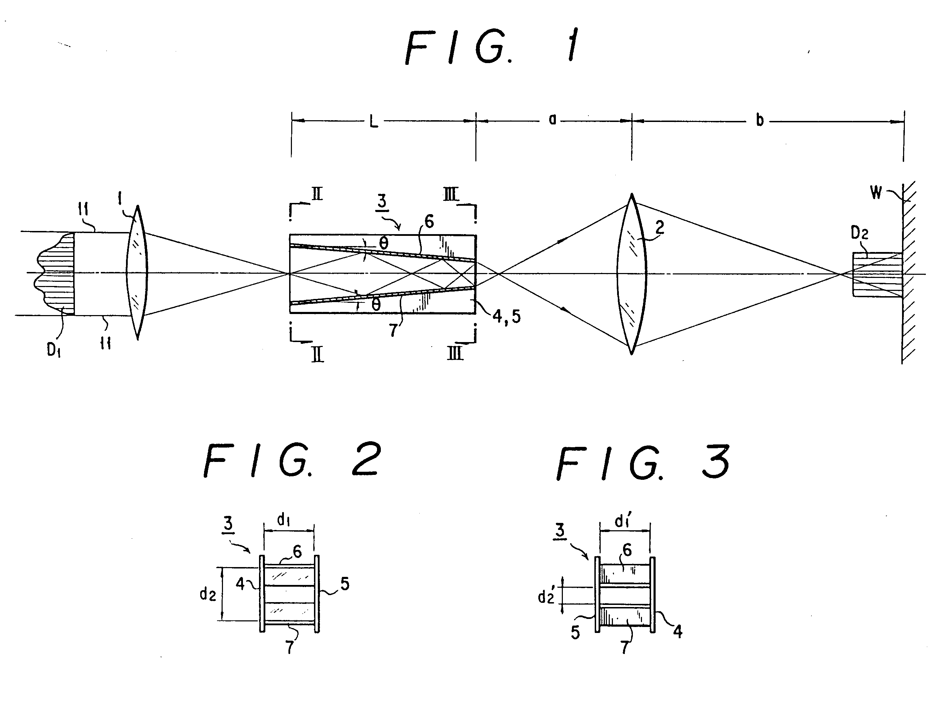

The first embodiment is shown in Figure 1. The light beam optical system, for example, the laser beam optical system shown is arranged to convert unevenly distributed beams $D_1$ of any given shape into uniformly distributed beams $D_2$ over a single zone or plural zones. In Figure 1, reference numeral 1 denotes a beam focussing lens, 2 an image forming lens, and 3 a sleeve member having a reflective inside surface interposed between lenses 1 and 2. Further, the sleeve member 3 having a reflective inside surface should preferably be of water-cooled type. The above-mentioned beam focussing lens 1 serves to introduce the laser beams into the inlet of the above-mentioned sleeve member 3 having a reflective inside surface. The above-mentioned image forming lens 2 serves to enlarge or reduce the laser beams which emerge from the outlet of the sleeve member 3 having a reflective inside surface, into a predetermined size. Accordingly, the optical system may be constituted by mirrors (reflective mirrors) instead of these lenses 1 and 2. Reference character W denotes a work to be irradiated by predetermined uniformly distributed beams $D_2$. As shown in Figures 2 and 3, the above-mentioned sleeve member 3 having a reflective inside surface is arranged to form a beam reflecting zone of a square sectional shape. The sleeve member 3 is constituted by a pair of left and right side plates 4 and 5, an upper plate 6 and a lower plate 7 which are mounted between both side plates 4 and 5 so that their positions can be varied freely. The inside surfaces of the plates 4, 5, 6 and 7 are mirror-finished to allow the laser beams introduced therein to be subjected to multiple-reflection. The upper and lower plates 6 and 7 are inclined by an angle ($\theta$) so that the size (sectional area $d'_1 \times d'_2$) of the outlet is smaller than the size (sectional area $d_1 \times d_2$) of the inlet or vice versa. In Figure 1, both the side plates 4 and 5 are located in parallel relationship with each other, and the upper and lower plates 6 and 7 are inclined, respectively, by an angle ($\theta$) so that they approach towards each other from the inlet for laser beams to the outlet thereof. That is to say, the sleeve member 3 having a reflective inside surface of a wedge shape is shown. In this case, as can be seen from Figures 2 and 3, the inlet has a square section having dimensions of $d_1 \times d_2$ ($d_1 = d_2$), whilst the outlet has a rectangular section having dimensions of $d'_1 \times d'_2$. Stating briefly, when the unevenly distributed incident beams are introduced through the beam focusing lens 1 into the inlet of the sleeve member 3 having a reflective inside surface, the beams are subjected to multiple-reflection within the beam reflection zone in the sleeve member 3 so as to be converted into beams of a predetermined shape having a macroscopically uniform intensity distribution when emerging from the outlet. The laser beams will form a uniform, rectangular image on the surface of the sample or work W through the action of the image forming lens 2. The reason for the use of the above-mentioned expression "macroscopically uniform intensity distribution" is that, since the laser beams obtained by the optical system of the kind specified above include interference fringes, they are not uniformly distributed locally. By varying the positions of the upper and lower plates 6 and 7, the shape of the laser beams may be varied continuously. Further, by varying the distance between the outlet of the sleeve member 3 having a reflective inside surface and the image forming lens 2 and that between the image forming lens 2 and the surface of the sample or work, the size of the laser beams can be varied continuously.

In the meantime, a case where the upper and lower plates 6 and 7 of the above-mentioned sleeve member 3 having a reflective inside surface are located in parallel relationship with each other (this embodiment does not fall within the scope of the claims) and the laser beams introduced into the sleeve member are changed into beams of a square section will be described below. In general, the more the number of reflections of laser beams in the sleeve member 3 having a reflective inside surface, the more uniform the macroscopic distribution of laser beams at the outlet of the sleeve member 3. In case the upper and lower plates 6 and 7 are located in parallel relationship with each other ($\theta = 0$) to form a uniform square section, the macroscopic laser beam distribution obtained by the internal reflection can be made uniform by selecting the length (L) of the sleeve member within the range given by the following formula:

$$L = (3 \sim 5) \cdot d \cdot f/D \qquad (1)$$

wherein "d" denotes the length of the side of the sleeve member 3 having a reflective inside surface, "f" the focal length of the beam focussing lens, and "D" the diameter of the incident beams.

Further, in case of the sleeve member 3 having reflective inside surface of a square section where interference fringes may be formed, the number N of the main interference fringes attributable to the formation of laser beams at that time is given by the following formula:

$$N = d^2/\lambda \cdot L \qquad (2)$$

wherein $\lambda$ denotes the wave length of the incident laser beams. Therefore, in case it is desired to form laser beams of a square shape to be irradiated, a predetermined number of interference fringes is given by the following formula:

$$N = d \cdot D/(3 \sim 5) \cdot \lambda \cdot f \qquad (3)$$

In case of obtaining laser beams for irradiation having a macroscopically uniform intensity (energy distribution), the number N of the interference fringes is inversely proportional to the length L of the sleeve member 3.

Whilst, in case the shape of the beams is changed into a rectangular one having a limited range of length L, it is not always possible to reconcile the macroscopic uniformity in the intensity of beams to the security of a sufficient number of interference fringes over both long and short sides of the section. Stating in brief, since the number of reflections made by the upper and lower plates 6 and 7 which form the long side is less than that of reflections made by the side plates 4 and 5 which form the short side, the length L of the sleeve member 3 required to ensure a macroscopic uniformity is determined by the long side and given by the following formula:

$$L = (3 \sim 5) \cdot d_1 \cdot f/D \qquad (4)$$

The number of the interference fringes on the long side is given by the following formula:

$$N_1 = d_1 \cdot D/(3 \sim 5) \cdot \lambda \cdot f \qquad (5)$$

whilst, the number of the interference fringes on the short side is given by the following formula:

$$N_2 = d_1 \cdot D/(3 \sim 5) \cdot \lambda \cdot f \cdot (d_2/d_1)^2 \qquad (6)$$

wherein "$d_1$" denotes the length of the long side, "$d_2$" the length of the short side, "$\lambda$" the wavelength of the incident beams, "f" the focal length of the beam focussing lens, "D" the diameter of the incident beams, "$N_1$" the number of the interference fringes measured along the long side, and "$N_2$" the number of the interference fringes measured along the short side. Therefore, in case of rectangular beams having a large aspect ratio ($d_1/d_2$), even if the number $N_1$ of the interference fringes on the long side is proper, the number $N_2$ of the interference fringes on the short side becomes smaller at the inverse square of the aspect ratio. Therefore, in case it is necessary to take a large aspect ratio and secure a sufficient number of interference fringes on the long side, it is necessary to take a large value for $d_1$. In this case,

however, the length L of the sleeve member 3 having a reflective inside surface needs to be increased according to the formula (3), and so the size of the sleeve member 3 will become inevitably huge.

Hereupon, the number of reflections of the beams can be increased sharply by inclining the upper and lower plates 6 and 7 of the sleeve member 3 having a reflective inside surface by an angle ($\theta$), defining the section of the outlet to obtain a beam shape of the size required ($d'_1$ x $d'_2$) and defining the section of the inlet to have a size required to secure a sufficient number of interference fringes, as shown in Figures 1, 2 and 3. Therefore, it becomes possible to change the beam shape (aspect ratio) having a macroscopically uniform intensity distribution into any desired value and change the number of interference fringes independently. In other words, even in the case where the aspect ratio of the beams on the surface of the work or sample is large, the number of reflections made by the side plates 4, 5 can be made equal to that of reflections made by upper and lower plates 6, 7. Further, by using the sleeve member 3 having inclined reflective inside surfaces, even in case of forming square beams, it becomes possible to increase the number of reflections beyond the value obtained by the abovementioned formula (1) with a limited length L of the sleeve member 3.

Incidentally, when the above-mentioned sleeve member 3 having a reflective inside surface inclined by a predetermined angle is used, the number of reflections obtained thereby will increase beyond that obtained in the case where the upper and lower plates 6 and 7 are located in parallel relationship with each other. However, the beam absorption losses on the surface of the mirror may become high. In such a case, a combination of a cylindrical lens (or cylindrical mirror) and a convex lens may be used instead of the above-mentioned beam focussing lens 1 or alternatively, the astigmatism of a spherical mirror may be utilized. By so doing, it becomes possible to increase or decrease the number of reflections. Further, although the sleeve member 3 having a reflective inside surface and whose outlet is smaller than the inlet is shown in Figure 1, it becomes possible to reduce the number of reflections, as occasion demands, by locating the upper and lower plates 6 and 7 so as to incline by a predetermined angle to diverge towards the outlet or reduce the number of interference fringes along one side thereof.

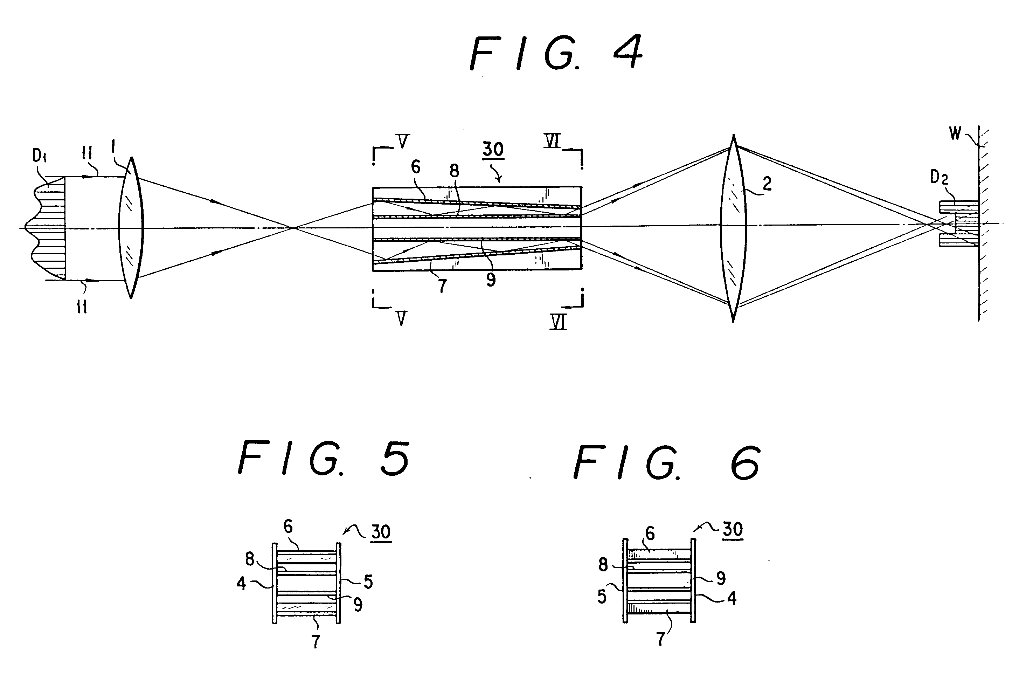

The second embodiment of the present invention is shown in Figure 4. As is obvious from Figures 5 and 6, a sleeve member 30 having reflective inside surfaces in this embodiment comprises four plates, i.e., an upper plate 6, intermediate stage plates 8, 9 and a lower plate 7 mounted between a pair of left and right side plates 4 and 5 so that the plates 6, 7, 8 and 9 may be changed freely in position. Stating in brief, the previously mentioned embodiment has a single beam reflecting zone, whilst this embodiment has a plurality of beam reflecting zones. Accordingly, both the upper and lower surfaces of each of the intermediate stage plates 8, 9 are mirror-finished. By using the sleeve member 30 having reflective inside surfaces of such a construction, it is possible to produce laser beams which are uniform over the plurality of beam reflecting zones and whose intensities are different between the zones. Accordingly, it is possible to satisfactorily harden curved surfaces of gears, for example.

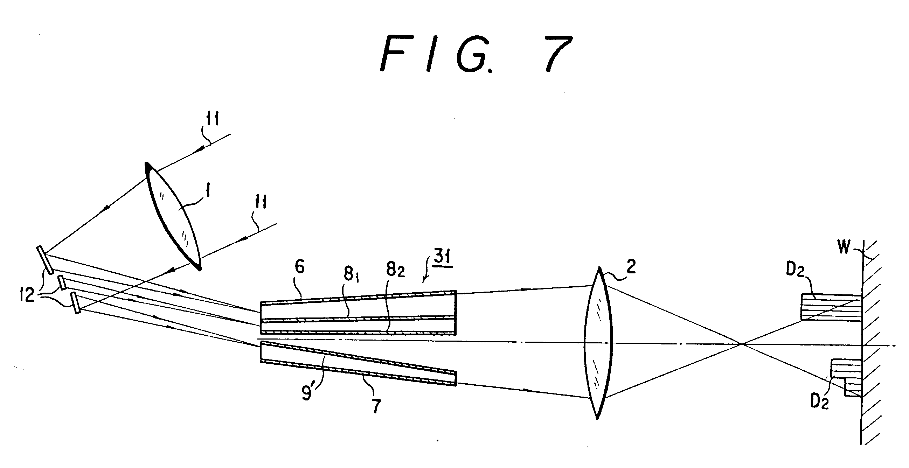

Further, the third embodiment of the present invention is shown in Figure 7. As shown in this drawing, it is not always necessary to locate the beam reflecting zones adjacent to one another at the outlet of a sleeve member 31 having reflective inside surfaces, and instead five plates, i.e., an upper plate 6, a lower plate 7 and plates $8_1$, $8_2$ and 9' may be spaced apart and formed with different shapes. The aforementioned second embodiment is suited to regulate the proportion of the area occupied by the beams at the inlet of the sleeve member 31 having reflective inside surfaces (the proportion of the dome power to be distributed to each of the beam reflecting zones), whilst this third embodiment is suited to the case where a plurality of reflecting mirrors 12 are used. Further, although in each of the above-mentioned embodiments the arrangement wherein the plate members 6 to 9' of the sleeve member 31 having reflective inside surfaces can be moved only in the vertical direction (or primary dimensional direction) was described as an example, it is obvious that the plate members may be moved transversely (or secondary dimensional direction). Further, the section of the beam reflecting zone of the sleeve member 3 having a reflective inside surface is not to be limited to square, but it may be round, for example, and alternatively if neglecting the uniformity to some degree, it is possible to form the section of the beam reflecting zone in a polygonal or elliptical shape or a composite shape of them.

In the next place, the forth and fifth embodiments of the present invention will be described with reference to Figures 8 and 9.

In Figure 8, a beam focussing lens 1 is mounted inside a sleeve member 13 to focus laser beams 11 on the side of the inlet, and on the side of the outlet a laser beam reflecting pipe 32 which serves as the sleeve member having a reflective inside surface is located opposite to an image forming lens 2 on the side of the outlet. The inside surface of the laser beam reflecting pipe 32 is mirror-finished to provide an extremely excellent reflectivity and is bent in generally L shape or at right angles, whilst the image forming lens 2 is located opposite to the side surface S of a work $W_1$.

Thus, the incident laser beams 11 having uneven distribution $D_1$ are focussed by the focussing lens 1 located on the surface of the inlet, and then projected onto the inside surface of the laser beam reflecting pipe 32 so that they may be subjected to the multi-reflection by the inside surface thereof, and subsequently synthesized at the outlet of the pipe 32 to produce beams having a uniform and completely rectangular energy distribution. Therefore, the energy distribution of the laser beams to be irradiated through the image forming lens 2 on the side of the outlet onto the side surface S of the work $W_1$ will become uniform and completely rectangular, as shown by $D_2$ in Figure 8.

Further, each of the beam focussing lenses and the laser beam reflecting pipe 32 may be provided with cooling means, as occasion demands.

The above-mentioned fourth and fifth embodiments are characterized in that laser beams having a uniform energy distribution can be irradiated by the compact and inexpensive apparatus which is the same as those used in the first, second and third embodiments, and also the laser beams can be irradiated in any desired direction to any desired position.

Further, the sixth embodiment of the present invention will be described below with reference to Figures 10 to 12.

In Figure 10, reference numeral 33a denotes a cylindrical sleeve member whose inside surface is mirror-finished to cause reflection. Further, inside the sleeve member 33a, there is mounted concentrically a conical mirror 33b whose outer peripheral surface is mirror-finished. The sleeve member 33a having a reflective inside surface and the mirror 33b constitutes a scope 33. Further, reference numeral 1 denotes a beam focussing lens installed on the side of the inlet of the scope 33, and 2 an image forming lens installed on the side of the outlet of the scope 33. The beam focussing lens 1 and the image forming lens 2 are located so that their respective optical axes are aligned with the central axis of the sleeve member of the scope 33. Reference numeral 11 denotes incident laser beams having an uneven energy distribution. By allowing the laser beams to pass through the optical system according to the sixth embodiment which includes the scope 33 adapted to cause multiple-reflection of the beams, it is possible to irradiate laser beams of a ring shape having a uniform energy distribution $D_2$ as shown in Figure 11 onto the work W.

A characteristic feature of this sixth embodiment resides in that, as mentioned above, the conical mirror 33b is merely concentrically disposed in the sleeve member 33a having a reflective inside surface in order to obtain laser beams of a ring mode, and there is no driving unit so that the stability of the laser beams having a uniform energy distribution thus formed can be improved significantly.

Further, Figure 12 shows laser hardening as one example of applications of the apparatus according to the present invention wherein laser beams of a ring mode are applied to the surface of a seat. In case of hardening the seat surface having such a cylindrical configuration by means of laser beams, if the conventional method of hardening which includes movement of spot beams is applied, a softening layer (joint) will be created at the terminal site of hardening; however, when the zone to be hardened is irradiated and heated by laser beams of a ring mode as proposed by the present invention, it is possible to carry out a sound hardening without causing any softening layer.

The foregoing description is merely made to exemplify preferred embodiments of the present invention, and the scope of the present invention is not to be limited thereto. Other modifications and changes of the present invention are intended to fall within the scope of the claims.

## Claims

1. A laser beam forming apparatus comprising a sleeve member (3; 3O; 31; 33) having a reflective wedge-shaped inside surface portion and mounted between at least one beam focussing lens (1) and an image forming lens (2) which are included in a laser beam optical system, characterized in that, for forming laser beams used for laser machining such as laser cutting, laser welding and laser hardening, the sectional area of said reflective inside surface portion is gradually reduced from its inlet toward its outlet, whereby the laser beams passing through the inside of said sleeve member are subjected to direct multiple-reflection at said inside surface portion efficiently.

2. The laser beam forming apparatus as claimed in claim 1, wherein said reflective inside surface portion has a quadrangular shape.

3. The laser beam forming apparatus as claimed in claim 1, wherein said reflective inside surface portion has a shape of revolution.

**4.** The laser beam forming apparatus as claimed in claim 1, wherein a combination of a cylindrical lens or a cylindrical mirror and a convex lens is used as said beam focussing lens.

**5.** The laser beam forming apparatus as claimed in claim 1, wherein a spherical mirror is used as said beam focussing lens.

**6.** The laser beam forming apparatus as claimed in claim 2, wherein said quadrangular reflective inside surface portion is formed by a pair of side mirror plates (4, 5) located in parallel with each other, and a pair of upper and lower mirror plates (6, 7) mounted between both the side mirror plates (4, 5) so that their respective inclinations can be varied freely.

**7.** The laser beam forming apparatus as claimed in claim 2, wherein said quadrangular reflective inside surface portion is formed by a pair of side mirror plates (4, 5) and a pair of upper and lower mirror plates (6, 7), all the mirror plates (4-7) being freely movable in their respective inclinations.

**8.** The laser beam forming apparatus as claimed in claim 2, wherein said quadrangular reflective inside surface portion is divided by a plurality of mirror plates (4-9) so as to enable a plurality of beam reflecting zones to be formed therein.

**9.** The laser beam forming apparatus as claimed in claim 3, wherein said reflective inside surface portion comprises a scope in which a conical mirror having a mirror-finished outer surface is concentrically mounted so that laser beams of a ring mode can be formed.

**10.** A laser beam forming apparatus comprising a sleeve member (32) having a reflective inside surface and disposed between at least one beam focussing lens (1) and an image forming lens (2) in a laser beam optical system for irradiating a laser beam onto a surface to be processed, characterized in that, for forming laser beams used for laser machining such as laser cutting, laser welding and laser hardening, said reflective inside surface portion is formed in a bent laser beam reflecting pipe (32), whereby the laser beams (11) passing through the inside of said sleeve member are subjected to direct multiple-reflection at said inside surface portion efficiently.

**Patentansprüche**

**1.** Vorrichtung zum Formen eines Laserstrahls mit einem Hülsenelement (3; 30; 31; 33), das einen eine reflektierende, keilförmige Innenfläche aufweisenden Abschnitt aufweist und das zwischen mindestens einer Sammellinse (1) und einer Abbildungslinse (2) angeordnet ist, die in einem optischen System für Laserstrahlen enthalten ist,
dadurch gekennzeichnet,
daß zum Formen von Laserstrahlen, die für die Laserbearbeitung, wie Laserschneiden, Laserschweißen und Laserhärten, verwendet werden, die von dem die reflektierende Innenfläche aufweisenden Abschnitt gebildete Querschnittsfläche vom Einlaß zum Auslaß fortschreitend abnimmt, wobei die durch das Innere des Hülsenelementes hindurchtretenden Laserstrahlen an dem die Innenfläche aufweisenden Abschnitt einer direkten Mehrfachreflektion unterworfen werden.

**2.** Vorrichtung nach Anspruch 1, dadurch gekennzeichnet, daß der die reflektierende Innenfläche aufweisende Abschnitt eine viereckige Gestalt aufweist.

**3.** Vorrichtung nach Anspruch 1, dadurch gekennzeichnet, daß der die reflektierende Innenfläche aufweisende Abschnitt die Gestalt eines Rotationskörpers aufweist.

**4.** Vorrichtung nach Anspruch 1, dadurch gekennzeichnet, daß anstelle der Sammellinse die Kombination aus einer Zylinderlinse oder einem zylindrischen Spiegel und einer Konvexlinse verwendet wird.

**5.** Vorrichtung nach Anspruch 1, dadurch gekennzeichnet, daß ein sphärischer Spiegel anstelle der Sammellinse verwendet wird.

**6.** Vorrichtung nach Anspruch 2, dadurch gekennzeichnet, daß der die reflektierende Innenflächen aufweisende Abschnitt mit viereckiger Gestalt durch ein Paar seitlicher Spiegelplatten (4, 5), die parallel zueinander angeordnet sind, und einem Paar oberer und unterer Spiegelplatten (6 und 7) gebildet ist, die zwischen den beiden seitlichen Spiegelplatten (4, 5) angeordnet sind, so daß ihre entsprechenden Neigungen frei verändert werden können.

**7.** Vorrichtung nach Anspruch 2, dadurch gekennzeichnet, daß der die reflektierende Innenfläche aufweisende Abschnitt mit viereckiger Gestalt durch ein Paar seitlicher Spiegelplatten (4, 5) und einem Paar oberer und unterer Spiegelplatten (6, 7) gebildet ist, wobei alle Spiegelplatten bezüglich ihrer entsprechenden Neigungen frei beweglich sind.

8. Vorrichtung nach Anspruch 2, dadurch gekennzeichnet, daß der die reflektierende Innenfläche aufweisende Abschnitt mit viereckiger Form durch eine Vielzahl von Spiegelplatten (4 bis 9) unterteilt ist, so daß darin eine Vielzahl von Strahlreflektionszonen gebildet werden.

9. Vorrichtung nach Anspruch 3, dadurch gekennzeichnet, daß der mit reflektierenden Innenflächen versehene Abschnitt ein Skopus umfaßt, in dem ein konischer Spiegel mit einer spiegelnden Außenfläche konzentrisch angeordnet ist, so daß ringförmige Laserstrahlen gebildet werden können.

10. Vorrichtung zur Erzeugung eines Laserstrahles mit einem Hülsenelement (32), das einen eine reflektierende Innenfläche aufweisenden Abschnitt aufweist und das in einem optischen System für Laserstrahlen zur Bestrahlung von zu bearbeitenden Oberflächen zwischen einer Sammellinse (1) und einer Abbildungslinse (2) angeordnet ist, dadurch gekennzeichnet,
daß zur Formung von Laserstrahlen, die für die Laserbearbeitung, wie Laserschneiden, Laserschweißen und Laserhärten, der die reflektierende Innenfläche aufweisende Abschnitt als gebogenes, einen Laserstrahl reflektierendes Rohrstück (32) ausgebildet ist, wobei die durch das Innere des Hülsenelementes hindurchtretenden Laserstrahlen (11) an dem die reflektierende Innenfläche aufweisenden Abschnitt einer direkten Mehrfachreflektion unterworfen werden.

**Revendications**

1. Appareil de formation d'un faisceau laser, comprenant un élément en forme de manchon (3 ; 30 ; 31 ; 13) qui comporte une partie formant surface intérieure réfléchissante en forme de coin et qui est monté entre au moins élément optique de focalisation de faisceau (1) et un élément optique de formation d'image (2) qui font partie d'un système optique à faisceau laser, caractérisé en ce que, pour former des faisceaux laser utilisés pour un usinage laser tel que découpage laser, soudage laser et trempe laser, l'aire de la section transversale de la partie formant surface intérieure réfléchissante diminue progressivement de son entrée à sa sortie, de sorte que les faisceaux laser traversant intérieurement l'élément en forme de manchon sont soumis efficacement à des réflexions multiples directes sur la partie formant surface intérieure.

2. Appareil de formation de faisceau laser suivant la revendication 1, dans lequel la partie formant surface intérieure réfléchissante a une forme quadrangulaire.

3. Appareil de formation de faisceau laser suivant la revendication 1, dans lequel la partie formant surface intérieure réfléchissante a une forme de révolution.

4. Appareil de formation de faisceau laser suivant la revendication 1, dans lequel la combinaison d'une lente cylindrique ou d'un miroir cylindrique et d'une lentille convexe est utilisée pour constituer l'élément optique de focalisation de faisceau.

5. Appareil de formation de faisceau laser suivant la revendication 1, dans lequel un miroir sphérique est utilisé pour constituer l'élément optique de focalisation de faisceau.

6. Appareil de formation de faisceau laser suivant la revendication 2, dans lequel la partie formant surface intérieure réfléchissante de forme quadrangulaire est formée de deux miroirs plans latéraux (4, 5), disposés parallèlement l'un à l'autre, et d'un miroir plan supérieur (6) et un miroir plan inférieur (7) montés entre les deux miroirs plans latéraux (4, 5), de façon telle qu'on puisse faire varier librement leurs inclinaisons respectives.

7. Appareil de formation de faisceau laser suivant la revendication 2, dans lequel la partie formant surface intérieure réfléchissante de forme quadrangulaire est formée de deux miroirs plans latéraux (4, 5) et d'un miroir plan supérieur (6) et un miroir plan inférieur (7), tous les miroirs plans (4-7) étant mobiles librement en ce qui concerne leurs inclinaisons respectives.

8. Appareil de formation de faisceau laser suivant la revendication 2, dans lequel la partie formant surface intérieure réfléchissante de forme parallélépipédique est divisée au moyen de plusieurs miroirs plans (4-9) de façon qu'il soit formé dans cette partie plusieurs zones réfléchissant les faisceaux.

9. Appareil de formation de faisceau laser suivant la revendication 3, dans lequel la partie formant surface intérieure réfléchissante est constituée d'un dispositif optique dans lequel un miroir conique ayant une surface extérieure à poli spéculaire est monté suivant le même axe, de façon telle que des faisceaux laser à mode annulaire puissent être formés.

10. Appareil de formation de faisceau laser, comprenant un élément en forme de manchon (32) qui comporte une surface intérieure réfléchissante et est disposé entre au moins un élément optique de focalisation de faisceau (1) et un élément optique de formation d'image (2) faisant partie d'un système optique pour faisceau laser permettant de projeter un faisceau laser sur une surface à traiter, caractérisé en ce que, pour former des faisceaux laser utilisés pour un usinage laser tel que découpage laser, soudage laser et trempe laser, la partie formant surface intérieure réfléchissante est formée dans un tuyau coudé (32) réfléchissant les faisceaux laser, de sorte que les faisceaux laser (11) traversant intérieurement l'élément en forme de manchon sont soumis efficacement à des réflexions multiples directes sur ladite partie formant surface intérieure.

# FIG. 1

# FIG. 2

# FIG. 3

EP 0 282 593 B1

# FIG. 4

# FIG. 5

# FIG. 6

EP 0 282 593 B1

# FIG. 7

EP 0 282 593 B1

EP 0 282 593 B1

F I G. 8

F I G. 9

13

# F I G. 10

# FIG. 11

D2

# FIG. 12

D2

P

W